# DEMANDE DE BREVET EUROPEEN

(11) **EP 4 415 054 A1**
(43) Date de publication de la demande: **14.08.2024**
(21) Numéro de dépôt: 24156060.6
(22) Date de dépôt: 06.02.2024
(51) Int. Cl.: H01L 29/778, H01L 21/337, H01L 29/10, H01L 29/41, H01L 29/20

(54) **TRANSISTOR HEMT**

(30) Priorité: 10.02.2023 FR 2301258
(71) Demandeur: STMicroelectronics International N.V., 1228 Plan-les-Ouates, Geneva (CH)
(72) Inventeur: CONSTANT, Aurore, 37100 TOURS (FR); IUCOLANO, Ferdinando, 95030 GRAVINA DI CATANIA (IT); TRINGALI, Cristina, 96011 AUGUSTA (IT); CASTAGNA, Maria Eloisa, 95123 CATANIA (IT)
(74) Mandataire: Cabinet Beaumont

(57) **Abrégé**

La présente description concerne un transistor HEMT (11) comportant :
- une première couche semiconductrice (13) ;
- une grille (15) disposée sur une première face de la première couche semiconductrice (13) ; et
- une première couche de passivation (17) en un premier matériau diélectrique s'étendant sur ladite première face de la première couche semiconductrice, les flancs de la grille (15) et au moins une partie périphérique d'une face de la grille opposée à la première couche semiconductrice,
dans lequel une deuxième couche de passivation (25) en un deuxième matériau diélectrique s'étend entre ladite face de la grille et la première couche de passivation, les flancs de la grille (15) n'étant pas revêtus par ladite deuxième couche de passivation (25).

## Description

### Domaine technique

La présente description concerne de façon générale le domaine des transistors et plus particulièrement le domaine des transistors à haute mobilité électronique aussi appelés HEMT (de l'anglais "High Electron Mobility Transistor").

### Technique antérieure

Les transistors HEMT reposent sur une hétérojonction en surface de laquelle se forme un gaz bidimensionnel d'électrons appelé 2DEG.

Il existe un besoin d'amélioration des transistors HEMT et de leurs procédés de fabrication.

### Résumé de l'invention

Pour cela, un mode de réalisation prévoit un transistor HEMT comportant :
- une première couche semiconductrice ;
- une grille disposée sur une première face de la première couche semiconductrice ; et
- une première couche de passivation en un premier matériau diélectrique s'étendant sur ladite première face de la première couche semiconductrice, les flancs de la grille et au moins une partie périphérique d'une face de la grille opposée à la première couche semiconductrice, dans lequel une deuxième couche de passivation en un deuxième matériau diélectrique s'étend entre ladite face de la grille et la première couche de passivation, les flancs de la grille n'étant pas revêtus par ladite deuxième couche de passivation.

Selon un mode de réalisation, la première couche semiconductrice est à base de nitrure de gallium.

Selon un mode de réalisation, la première couche semiconductrice est en nitrure d'aluminium-gallium.

Selon un mode de réalisation, la première couche de passivation est en alumine.

Selon un mode de réalisation, la deuxième couche de passivation est en nitrure.

Selon un mode de réalisation, la deuxième couche de passivation est en nitrure de silicium, en carbonitrure de silicium ou en nitrure d'aluminium.

Selon un mode de réalisation, la deuxième couche de passivation est en oxyde, par exemple en alumine ou en dioxyde de silicium.

Selon un mode de réalisation, le transistor comporte une deuxième couche semiconductrice en contact avec une deuxième face de la première couche semiconductrice, opposée à la première face.

Selon un mode de réalisation, la deuxième couche semiconductrice est en nitrure de gallium.

Selon un mode de réalisation, le transistor comporte une métallisation de contact de source et une métallisation de contact de drain, disposées respectivement de part et d'autre de la grille.

Un autre mode de réalisation prévoit un circuit de conversion ou d'adaptation de puissance comportant au moins un transistor tel que défini ci-dessus.

Un autre mode de réalisation prévoit un procédé de formation d'un transistor HEMT comportant les étapes suivantes :
a) former une première couche semiconductrice ;
b) former une grille disposée sur une première face de la première couche semiconductrice ; et
c) former une première couche de passivation en un premier matériau diélectrique s'étendant sur ladite première face de la première couche semiconductrice, les flancs de la grille et au moins une partie périphérique d'une face de la grille opposée à la première couche semiconductrice, et dans lequel une deuxième couche de passivation en un deuxième matériau diélectrique est formée entre ladite face de la grille et la première couche de passivation, les flancs de la grille n'étant pas revêtus par ladite deuxième couche de passivation.

Selon un mode de réalisation, le procédé comporte les étapes successives suivantes :
- dépôt d'une couche en le matériau de la grille sur la première face de la première couche semiconductrice;
- dépôt d'une couche en le deuxième matériau diélectrique sur toute la surface de la couche en le matériau de la grille ;
- gravure localisée, à travers un même masque de gravure, de la couche en le matériau de la grille et de la couche en le deuxième matériau diélectrique de façon à former respectivement la grille et la deuxième couche de passivation.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et schématique, d'un exemple d'un transistor HEMT selon un premier mode de réalisation ;
la figure 2A, la figure 2B, la figure 2C, la figure 2D, la figure 2E, la figure 2F et la figure 2G sont des vues en coupe illustrant des étapes d'un exemple d'un procédé de fabrication du transistor HEMT illustré en figure 1 ; et
la figure 3 est une vue en coupe, partielle et schématique, d'un exemple d'un transistor HEMT selon un deuxième mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les applications que peuvent avoir les transistors HEMT décrits ne sont pas détaillées, les modes de réalisation étant compatibles avec les applications usuelles des transistors HEMT. On s'intéresse ici tout particulièrement au domaine des transistors HEMT dits de puissance, capables de tenir des tensions relativement élevées à l'état bloqué, par exemple des tensions de l'ordre de 100 à 650 volts. Les transistors décrits peuvent, par exemple, être utilisés dans divers circuits de conversion ou d'adaptation de puissance, par exemple dans des équipements industriels, des dispositifs d'affichage ou d'éclairage, des équipements de télécommunications, des dispositifs automobiles, etc.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

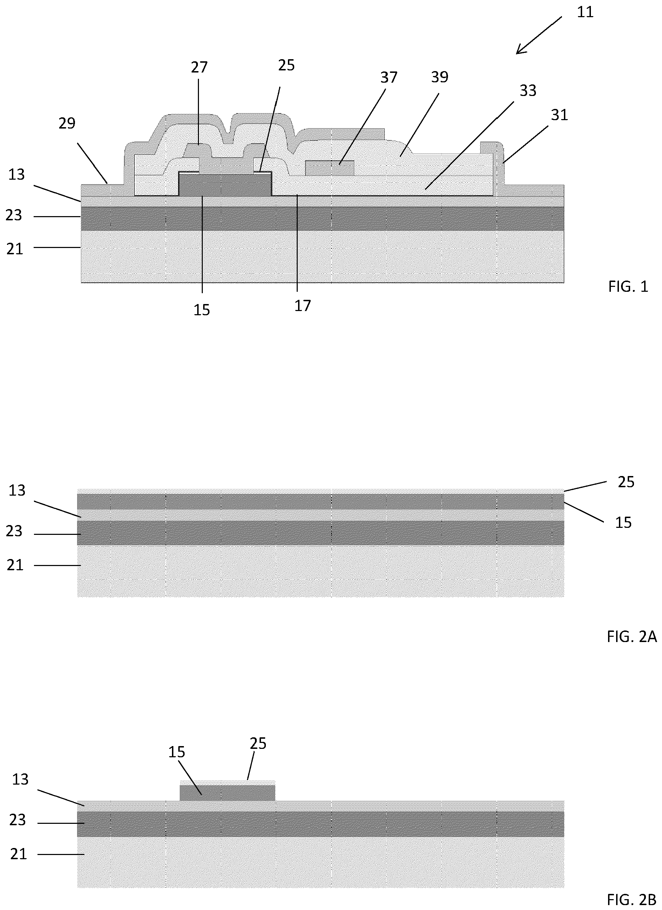

La figure 1 est une vue en coupe, partielle et schématique, d'un exemple d'un transistor HEMT 11 selon un mode de réalisation.

Le transistor HEMT 11 comporte une première couche semiconductrice 13 disposée sur une deuxième couche conductrice 23. La couche semiconductrice 23 est par exemple en contact, par sa face inférieure, avec la face supérieure de la couche conductrice 23. A titre d'exemple, l'empilement comprenant la couche semiconductrice 13 et la couche semiconductrice 23 repose sur un substrat 21. La couche semiconductrice 23 est par exemple en contact, par sa face inférieure, avec la face supérieure du substrat 21. L'interface entre la couche semiconductrice 13 et la couche semiconductrice 23 définit une hétérojonction à la surface de laquelle un gaz bidimensionnel d'électrons 2DEG aussi appelé canal d'électrons est formé.

Les couches semiconductrices 13 et 23 sont par exemple en des matériaux semiconducteurs de type III-V, par exemple à base de nitrure de gallium (GaN). La couche semiconductrice 13 est par exemple en nitrure d'aluminium-gallium (AlGaN). La couche semiconductrice 23 est par exemple en nitrure de gallium (GaN).

A titre d'exemple, le substrat 21 est en un matériau semiconducteur. Le substrat 21 est par exemple en silicium, ou en carbure de silicium. En variante, le substrat 21 est en nitrure d'aluminium. Le substrat 21 comprend par exemple, du côté de sa face supérieure, une couche tampon ("buffer layer" en anglais), non détaillée sur les figures, par exemple en nitrure de gallium. La couche tampon est par exemple en contact, par sa face supérieure, avec la face inférieure de la couche semiconductrice 23.

Le transistor HEMT 11 comporte une grille 15 sur la face supérieure de la couche semiconductrice 13. La grille 15 est par exemple en contact, par sa face inférieure, avec la face supérieure de la couche semiconductrice 13.

La grille 15 est par exemple en un matériau semiconducteur, par exemple en un matériau semiconducteur de type III-V, par exemple en nitrure de gallium, par exemple dopé de type P.

A titre d'exemple, le transistor HEMT 11 comprend, en outre, une métallisation de contact de source 29 et une métallisation de contact de drain 31. A titre d'exemple, les métallisations de contact 29 et 31 sont à base de titane, de nitrure de titane et/ou d'un alliage d'aluminium et de cuivre. Les métallisations de contact de source 29 et de drain 31 définissent par exemple chacune un contact ohmique avec la couche semiconductrice 13. Les métallisations de contact 29 et 31 sont par exemple situées sur et en contact avec la couche semiconductrice 13, de part et d'autre de la grille 15.

Le transistor HEMT 11 comporte, de plus, une couche de passivation 25, en un matériau diélectrique, s'étendant sur la face supérieure de la grille 15 mais ne s'étendant pas sur les flancs de la grille. La couche de passivation 25 est par exemple en contact, par sa face inférieure avec la face supérieure de la grille 15.

La couche de passivation 25 a par exemple une épaisseur comprise entre 1 nm et 20 nm, par exemple comprise entre 1 nm et 10 nm, par exemple de l'ordre de 2 nm.

La couche de passivation 25 est par exemple en nitrure, par exemple en nitrure de silicium (Si₃N₄), en carbonitrure de silicium (SiOₓN_{y}) ou en nitrure d'aluminium (AlN) . La couche de passivation 25 est par exemple en oxyde, par exemple en alumine (Al₂O₃) ou en dioxyde de silicium (SiO₂).

Le transistor HEMT 11 comporte, en outre, une couche de passivation 17 recouvrant les flancs et au moins une partie de la face supérieure de la couche de passivation 25, les flancs de la grille 15 et se prolongeant sur une partie de la face supérieure de la couche semiconductrice 13 non recouverte par la grille 15. A titre d'exemple, la couche de passivation 17 est en contact, par sa face inférieure, avec la face supérieure de la couche semiconductrice 13. La couche de passivation 17 est par exemple en outre en contact avec les flancs de la grille 15. La couche de passivation 17 est par exemple en outre en contact, par sa face inférieure, avec la face supérieure de la couche semiconductrice 13. Dans le mode de réalisation de la figure 1, la couche de passivation 17 s'étend latéralement entre les métallisations de contact de source 29 et de drain 31.

La couche de passivation 17 a par exemple une épaisseur comprise entre 2 nm et 20 nm, par exemple comprise entre 2 nm et 10 nm, par exemple de l'ordre de 5 nm. La couche de passivation 17 est par exemple en un matériau diélectrique, par exemple en alumine (Al₂O₃), en dioxyde de silicium (SiO₂), en nitrure d'aluminium (AlN) ou en acide d'hafnium (HfO₂).

La grille 15 est par exemple surmontée par une métallisation de contact de grille 27.

A titre d'exemple, la métallisation de contact de grille 27 est en contact, par sa face inférieure, avec la face supérieure de la grille 15. La métallisation de contact de grille 27 s'étend alors à travers les couches 17 et 25 qui ne recouvrent la face supérieure de la grille 15 que sur sa périphérie.

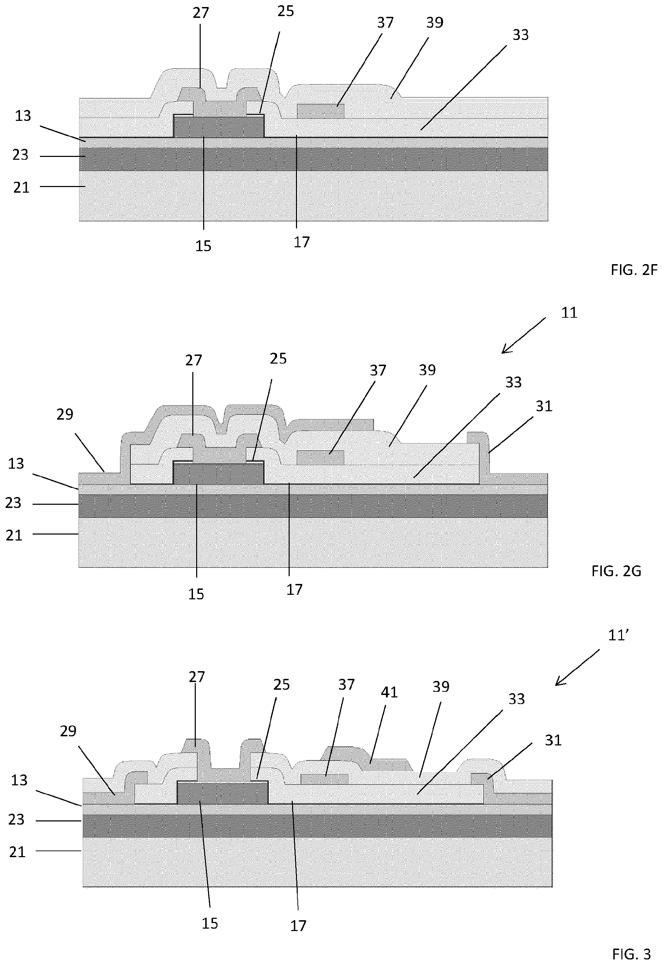

En variante, la métallisation de contact de grille 27 est en contact, par sa face inférieure, avec la face supérieure de la couche de passivation 25 qui s'étend sur toute la surface de la face supérieure de la grille 15. La métallisation de contact de grille 27 s'étend alors à travers la couche 17 qui ne recouvre la couche de passivation 25 que sur sa périphérie. Cette variante est illustrée par exemple par la figure 3 décrite ci-après.

A titre d'exemple, la métallisation de contact de grille 27 est à base de nitrure de titane et/ou de titane, et/ou de tantale, et/ou un alliage de tungstène et de tantale et/ou un alliage de tungstène et de titane et/ou d'un alliage d'aluminium et de cuivre.

Le transistor HEMT 11 comprend par exemple plusieurs niveaux de couches isolantes dans, et par exemple sur, lesquelles sont formés des métallisations.

A titre d'exemple, le transistor HEMT 11 comprend une couche isolante 33 sur et en contact avec la face supérieure de la couche de passivation 17. A titre d'exemple, la couche isolante 33 recouvre l'ensemble de la surface de la couche de passivation 17. La couche isolante 33 est par exemple ouverte en vis-à-vis d'une partie centrale de la face supérieure de la grille 15 de façon à être traversée par la métallisation de contact de grille 27. La couche isolante 33 est par exemple en un matériau diélectrique, par exemple en un oxyde, par exemple en dioxyde de silicium (SiO₂).

A titre d'exemple, le transistor HEMT 11 comprend une région métallique 37 s'étendant sur une partie de la surface de la couche isolante 33. A titre d'exemple, la région métallique 37 est à base de nitrure de titane et/ou de titane, et/ou de tantale, et/ou un alliage de tungstène et de tantale et/ou un alliage de tungstène et de titane et/ou d'un alliage d'aluminium et de cuivre. La région métallique 37 est par exemple en le même matériau que la métallisation de contact de grille 27.

Le transistor HEMT 11 peut comprendre une deuxième couche isolante 39 recouvrant l'ensemble de la structure à l'exception des métallisations de contact de source 29 et de drain 31. La deuxième couche isolante 39 est, par exemple en le même matériau que la couche isolante 33.

A titre d'exemple, la métallisation de contact de source 29 se prolonge sur la face supérieure de la couche isolante 39 en direction de la métallisation de contact de drain 31, sans atteindre la métallisation de contact de drain 31.

Dans le transistor de la figure 1, le canal 2DEG est par exemple normalement fermé (bloqué) ("normally-off" en anglais), c'est-à-dire qu'il est interrompu sous la grille 15 ce qui empêche la circulation d'un courant entre la source et le drain du transistor. On dit que le transistor est à l'état bloqué. Le canal peut être rétabli (c'est à dire rendu passant) par la polarisation de la grille 15. Dans ce cas, un courant peut s'établir entre la source et le drain du transistor. Les modes de réalisation décrits peuvent également s'appliquer à des transistors normalement ouverts (passants) ("normally-on" en anglais).

La présence de la couche de passivation 17 permet la protection de la face supérieure de la couche semiconductrice 13 sur laquelle des liaisons pendantes peuvent être présentes et susceptibles de générer des courants de fuite et/ou une diminution de la tenue en tension du transistor. La couche de passivation 17 comble ces liaisons afin de rendre la surface de la couche semiconductrice 13 électriquement inactive.

La couche de passivation 17 permet également de protéger la couche semiconductrice 13 contre l'oxydation et d'améliorer son état de surface auquel le canal 2DEG est sensible.

Alors que la couche de passivation 17 joue un rôle important dans la qualité et la durée de vie du transistor, sa présence peut entraîner l'accumulation d'électrons le long des flancs de la grille 15, sous la couche de passivation 17. Ce phénomène est par exemple accentué par l'endommagement des flancs de la grille causé par la gravure de la grille 15. La présence de la couche de passivation 25 sur la face supérieure de la grille 15 permet la réduction du courant de fuite latéral originaire de la face supérieure de la grille 15 et véhiculé par ces électrons.

La grille 15, formée préférentiellement par épitaxie, a par exemple une polarité gallium, c'est-à-dire que, dans son arrangement atomique, la grille 15 se termine au niveau de sa face supérieure par des atomes de gallium laissant ainsi des lacunes en azote à la surface de cette face. Un avantage dans la formation d'une deuxième couche de passivation 25 en nitrure à la surface de la face supérieure de la grille 15 est qu'elle permet de combler les lacunes en azote, présentes à la surface de la face supérieure de la grille 15, pouvant générer des courants de fuite.

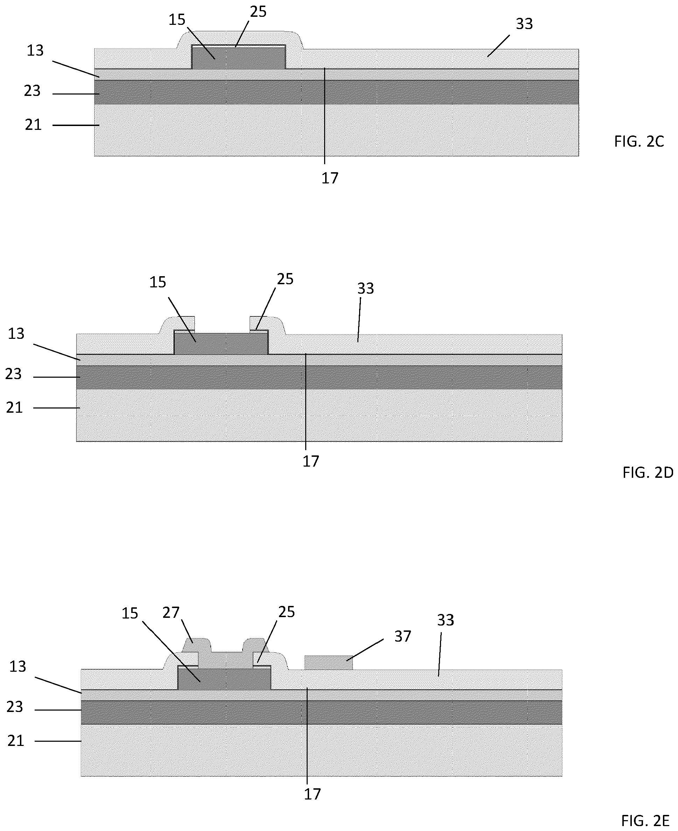

La figure 2A, la figure 2B, la figure 2C, la figure 2D, la figure 2E, la figure 2F et la figure 2G sont des vues en coupe illustrant des étapes successives d'un exemple d'un procédé de fabrication du transistor HEMT illustré en figure 1.

La figure 2A illustre une structure de départ comprenant, dans l'ordre, à partir de la face inférieure de la structure, le substrat 21, la deuxième couche semiconductrice 23 et la première couche semiconductrice 13. La structure de départ comprend, en outre, une couche de grille 15 surmontée de la couche de passivation 25. Dans la structure de départ illustrée en figure 2A, les couches 23, 13, 15 et 25 s'étendent chacune de façon continue et avec une épaisseur sensiblement uniforme sur toute la surface supérieure du substrat 21.

A titre d'exemple, la grille 15 est formée sur la face supérieure de la couche 13, par un procédé de dépôt en phase vapeur, par exemple un procédé d'épitaxie en phase vapeur organométallique aussi appelé procédé de dépôt chimique en phase vapeur organométallique ou MOCVD (de l'anglais "Metalorganic chemical vapor déposition"). A titre d'exemple, le dépôt de la grille 15 est réalisé sous un vide au moins partiel.

A titre d'exemple, la couche de passivation 25 est formée sur la face supérieure de la grille 15 par MOCVD, par exemple sous un vide au moins partiel. Dans cet exemple, la couche de passivation 25 et la grille 15 sont formées dans la même chambre sans rupture de vide entre les deux dépôts. Un tel procédé de dépôt est par exemple utilisé pour la formation d'une couche de passivation 25 en nitrure, par exemple en nitrure de silicium ou en nitrure d'aluminium.

En variante, la couche de passivation 25 est formée, sur la face supérieure de la grille 15, par un procédé de dépôt de couche atomique ou ALD (de l'anglais "Atomic Layer Déposition"). A titre d'exemple, le procédé de dépôt de la couche de passivation 25 est assisté par plasma. Un tel procédé de dépôt est par exemple utilisé pour la formation d'une couche de passivation 25 en nitrure, par exemple en nitrure de silicium, en nitrure d'aluminium ou en carbonitrure de silicium.

La figure 2B illustre une structure obtenue à l'issue d'une étape de gravure localisée de la couche de grille 15 et de la couche de passivation 25 de manière à conserver uniquement une portion de chaque couche formant l'empilement de grille du transistor de la figure 1.

Lors de cette étape, on vient graver la couche de passivation 25 par exemple par un procédé de gravure plasma, par exemple par un procédé de gravure plasma à base de chlore, par exemple par une gravure plasma en trichlorure de bore (BCl₃).

Lors de cette étape, on vient en outre graver la grille 15 par exemple par un procédé de gravure plasma, par exemple par un procédé de gravure plasma à base de chlore, par exemple par une gravure plasma en dichlore (Cl₂) et dioxygène (O₂).

A titre d'exemple, la grille 15 et la couche de passivation 25 sont gravées à travers un même masque. A l'issue de cette étape, la grille 15 et la couche de passivation 25 sont ainsi alignées, c'est-à-dire qu'elles ont leurs flancs alignés.

Les étapes de gravure de la grille 15 et de la couche de passivation 25 sont par exemple réalisées simultanément, c'est-à-dire qu'elles sont réalisées au sein d'une même chambre de gravure. En variante, les étapes de gravure de la grille 15 et de la couche de passivation 25 sont réalisées successivement l'une après l'autre.

Ces étapes de gravure sont par exemple suivies d'une étape de nettoyage de la face supérieure de la structure de façon à retirer par exemple les résidus issus du ou des masques de gravure et les impuretés issues de la gravure de la couche de passivation 25 et de la grille 15. Le nettoyage de la structure comporte par exemple une étape de décapage ("stripping" en anglais) par plasma de dioxygène et diazote (N₂). Le nettoyage de la structure peut en outre comporter une étape de retrait des résidus organiques à l'aide d'un solvant.

La figure 2C illustre une structure obtenue à l'issue d'une étape de formation de la couche de passivation 17 et de la couche isolante 33 sur la face supérieure de la structure illustrée en figure 2B.

Lors de cette étape, on vient dans un premier temps former la couche de passivation 17 pleine plaque, de sorte qu'elle recouvre l'ensemble de la face supérieure de la structure illustrée en figure 2B.

La couche de passivation 17 est, par exemple, formée en contact avec la face supérieure de la couche semiconductrice 13, les flancs de la grille 15 et les flancs et la face supérieure de la couche de passivation 25.

La couche de passivation 17 est par exemple formée par un procédé de dépôt de couche mince, par exemple par ALD. A titre d'exemple, le procédé de dépôt de la couche de passivation 17 est assisté par plasma.

Dans un second temps, on vient, dans cet exemple, former la couche isolante 33 pleine plaque, de sorte qu'elle recouvre l'ensemble de la face supérieure de la couche de passivation 17. La couche isolante 33 est par exemple formée en contact avec la couche de passivation 17. La couche isolante 33 est par exemple formée par un procédé de dépôt chimique en phase vapeur assisté par plasma ou PECVD (de l'anglais "Plasma-Enhanced Chemical Vapor Déposition"). A l'issue de cette étape, la couche isolante 33 a une épaisseur par exemple comprise entre 150 nm et 400 nm, par exemple comprise entre 200 nm et 350 nm, par exemple de l'ordre de 260 nm.

A titre d'exemple, les étapes de dépôt de la couche de passivation 17 et de la couche isolante 33 sont précédées d'une ou plusieurs étapes de préparation de la surface de la structure illustrée en figure 2B. La préparation de la surface de la structure illustrée en figure 2B peut comprendre un nettoyage consistant par exemple en un nettoyage chimique à l'aide d'acide, par exemple de chlorure d'hydrogène (HCl) et de fluorure d'hydrogène (HF). La préparation de la surface de la structure illustrée en figure 2B peut, en outre, comprendre un nettoyage consistant par exemple en une oxydation de surface. La couche de passivation 17 sera ainsi formée au contact d'un film en un matériau diélectrique, par exemple un oxyde, lui-même formé au contact de la face supérieure de la couche 13.

La figure 2D illustre une structure obtenue à l'issue d'une étape d'ouverture des couches 17, 25 et 33 en vis-à-vis de la grille 15 de la structure illustrée en figure 2C.

Plus particulièrement, lors de cette étape, on vient retirer les couches de passivation 17 et 25 et la couche isolante 33 en vis-à-vis d'une partie centrale de la face supérieure de la grille 15.

A titre d'exemple, cette étape comprend dans un premier temps le retrait de la couche 33 et dans un second temps le retrait des couches 17 et 25. A titre d'exemple, le retrait de la couche 33 est réalisé par gravure plasma, par exemple à base de fluor, par exemple à base de tétrafluorure de carbone (CF₄).

A titre d'exemple, le retrait des couches 17 et 25 est réalisé par gravure plasma, par exemple à base de chlore, par exemple à base de trichlorure de bore (BCl₃). Dans cet exemple, les couches 17 et 25 sont gravées de façon à dévoiler la face supérieure de la grille 15.

En variante, lors de cette étape, la couche de passivation 25 n'est pas retirée en vis-à-vis de la partie centrale de la face supérieure de la grille 15, la gravure de la couche de passivation 17 étant interrompue lorsque la face supérieure de la couche de passivation 25 est dévoilée.

Les gravures susmentionnées sont par exemple suivies d'une étape de nettoyage de la face supérieure de la structure, par exemple similairement à ce qui a été décrit en relation avec la figure 2B.

La figure 2E illustre une structure obtenue à l'issue d'une étape de formation de la métallisation 27 et de la région 37 sur la face supérieure de la structure illustrée en figure 2D.

Lors de cette étape, on vient par exemple former la métallisation de contact de grille 27 dans l'ouverture formée dans les couches 17 et 33 en vis-à-vis de la partie centrale de la grille 15. A titre d'exemple, la métallisation de contact de grille 27 est formée sur et en contact avec la face supérieure de la grille 15. En variante, la métallisation de contact de grille 27 est formée sur et en contact avec la face supérieure de la couche de passivation 25.

A titre d'exemple, lors de cette étape, on vient en outre former la région 37 sur une partie de la surface de la première couche isolante 33. La métallisation de contact de grille 27 et la région 37 sont, par exemple, formées par dépôt d'une ou plusieurs couches en un matériau métallique suivie d'une étape de gravure.

A titre d'exemple, l'étape de formation de la métallisation de contact de grille 27 et de la région 37 est précédée d'une étape de préparation de la surface de la structure illustrée en figure 2D, consistant par exemple en un nettoyage chimique à l'aide d'acide, par exemple de chlorure d'hydrogène (HCl).

La figure 2F illustre une structure obtenue à l'issue d'une étape de formation de la couche isolante 39 sur la face supérieure de la structure illustrée en figure 2E.

Lors de cette étape, on vient par exemple former la couche isolante 39 pleine plaque, de sorte qu'elle recouvre l'ensemble de la face supérieure de la structure illustrée en figure 2E, c'est-à-dire la face supérieure et les flancs de la métallisation de contact de grille 27 et de la région 37 et une partie de la couche 33. La couche isolante 39 est par exemple formée par un procédé identique au procédé de formation de la couche 33 décrit en relation avec la figure 2C. A l'issue de cette étape, la couche isolante 39 a une épaisseur par exemple comprise entre 150 nm et 400 nm, par exemple comprise entre 200 nm et 350 nm, par exemple de l'ordre de 260 nm.

La figure 2G illustre la structure obtenue à l'issue d'une étape de formation d'ouvertures localisées dans l'empilement des couches diélectriques 39, 33 et 17 de façon à dévoiler la face supérieure de la couche semiconductrice 13 en vis à vis de régions de reprise de contact de source et de drain du transistor, puis d'une étape de formation des métallisations de contact de source 29 et de drain 31 dans lesdites ouvertures. La structure ainsi obtenue est par exemple identique ou similaire à la structure illustrée en figure 1.

Les ouvertures destinées à recevoir les métallisations de contact de source 29 et de drain 31 sont par exemple formées par un procédé de gravure plasma, par exemple à base de fluor, par exemple à base de tétrafluorure de carbone (CF₄). La gravure susmentionnée est par exemple sélective et ne grave pas la couche semiconductrice 13 en nitrure de gallium. La gravure des couches 17, 33 et 39 s'arrête ainsi lorsque la face supérieure de la couche 13 est dévoilée. L'étape de formation des ouvertures destinées à recevoir les métallisations de contact 29 et 31 est par exemple suivie d'une étape de nettoyage de la face supérieure de la structure, par exemple similairement à ce qui a été décrit en relation avec la figure 2B. A titre d'exemple, une étape de préparation de la surface de la face supérieure de la couche 13 dans les ouvertures, en vue d'accueillir les métallisations de contacts 29 et 31, peut être prévue. Cette étape consiste par exemple en un nettoyage chimique à l'aide d'acide, par exemple de chlorure d'hydrogène (HCl).

Dans un second temps, les métallisations de contact de source 29 et de drain 31 sont, par exemple, formées dans les ouvertures précédemment réalisées. Les métallisations 29, 31 et la région 41 sont, par exemple, formées par dépôt d'une ou plusieurs couches en un matériau métallique sur l'ensemble de la face supérieure de la structure, ici la face supérieure des couches 13 et 39, suivie d'une étape de gravure pour délimiter latéralement les métallisations de contact de source 29 et de drain 31.

La figure 3 est une vue en coupe, partielle et schématique, d'un exemple d'un transistor HEMT 11' selon un deuxième mode de réalisation.

Le transistor 11' illustré en figure 3 est similaire au transistor 11 illustré en figure 1 à la différence près que, dans le procédé de fabrication du transistor 11', les métallisations de contact de source 29 et de drain 31 ont été formées avant la formation de la métallisation de contact de grille 27 alors que dans le procédé de fabrication du transistor 11, les métallisations de contacts de source 29 et de drain 31 ont été formées après la formation de la métallisation de contact de grille 27.

Plus particulièrement, dans cet exemple, le transistor 11' est différent du transistor 11 en ce que la métallisation de contact de grille 27 traverse la couche 39 et en ce que la couche 39 recouvre les métallisations de contact 29 et 31.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

En outre, bien que l'on ait décrit ci-dessus un exemple de réalisation dans lequel la grille 15 du transistor est en contact avec la face supérieure de la couche semiconductrice supérieure 13, à titre de variante, la grille 15 peut être séparée de la couche semiconductrice 13 par une couche d'isolant de grille.

Enfin, les modes de réalisation ne se limitent pas aux exemples de valeurs numériques ni aux exemples de matériaux mentionnés dans la présente description.

Enfin, la mise en oeuvre pratique des modes de réalisation et variantes décrits est à la portée de la personne du métier à partir des indications fonctionnelles données ci-dessus.

## Revendications

1. Transistor HEMT (11) comportant :
- une première couche semiconductrice (13) ;
- une grille (15) disposée sur une première face de la première couche semiconductrice (13) ; et
- une première couche de passivation (17) en un premier matériau diélectrique s'étendant sur ladite première face de la première couche semiconductrice, les flancs de la grille (15) et au moins une partie périphérique d'une face de la grille opposée à la première couche semiconductrice, dans lequel une deuxième couche de passivation (25) en un deuxième matériau diélectrique s'étend entre ladite face de la grille et la première couche de passivation, les flancs de la grille (15) n'étant pas revêtus par ladite deuxième couche de passivation (25).

2. Transistor selon la revendication 1, dans lequel la première couche semiconductrice (13) est à base de nitrure de gallium.

3. Transistor selon la revendication 2, dans lequel la première couche semiconductrice (13) est en nitrure d'aluminium-gallium.

4. Transistor selon l'une quelconque des revendications 1 à 3, dans lequel la première couche de passivation (17) est en alumine.

5. Transistor selon l'une quelconque des revendications 1 à 4, dans lequel la deuxième couche de passivation (25) est en nitrure.

6. Transistor selon la revendication 5, dans lequel la deuxième couche de passivation (25) est en nitrure de silicium, en carbonitrure de silicium ou en nitrure d'aluminium.

7. Transistor selon l'une quelconque des revendications 1 à 4, dans lequel la deuxième couche de passivation (25) est en oxyde, par exemple en alumine (Al₂O₃) ou en dioxyde de silicium (SiO₂).

8. Transistor selon l'une quelconque des revendications 1 à 7, comportant une deuxième couche semiconductrice (23) en contact avec une deuxième face de la première couche semiconductrice (13), opposée à la première face.

9. Transistor selon la revendication 8, dans lequel la deuxième couche semiconductrice (23) est en nitrure de gallium.

10. Transistor selon l'une quelconque des revendications 1 à 9, comportant une métallisation de contact de source (29) et une métallisation de contact de drain (31), disposées respectivement de part et d'autre de la grille (15) .

11. Circuit de conversion ou d'adaptation de puissance comportant au moins un transistor selon l'une quelconque des revendications 1 à 10.

12. Procédé de formation d'un transistor HEMT comportant les étapes suivantes :
a) former une première couche semiconductrice (13) ;
b) former une grille (15) disposée sur une première face de la première couche semiconductrice (13) ; et
c) former une première couche de passivation (17) en un premier matériau diélectrique s'étendant sur ladite première face de la première couche semiconductrice, les flancs de la grille (15) et au moins une partie périphérique d'une face de la grille opposée à la première couche semiconductrice,
et dans lequel une deuxième couche de passivation (25) en un deuxième matériau diélectrique est formée entre ladite face de la grille et la première couche de passivation, les flancs de la grille (15) n'étant pas revêtus par ladite deuxième couche de passivation (25).

13. Procédé selon la revendication 12, comportant les étapes successives suivantes :
- dépôt d'une couche en le matériau de la grille (15) sur la première face de la première couche semiconductrice (13) ;
- dépôt d'une couche en le deuxième matériau diélectrique sur toute la surface de la couche en le matériau de la grille (15) ;
- gravure localisée, à travers un même masque de gravure, de la couche en le matériau de la grille (15) et de la couche en le deuxième matériau diélectrique de façon à former respectivement la grille (15) et la deuxième couche de passivation (25) .
